# FASCICULE DE BREVET EUROPEEN

(11) **EP 0 605 300 B1**
(45) Date de publication et mention de la délivrance du brevet: **03.06.1998**
(21) Numéro de dépôt: 93403154.3
(22) Date de dépôt: 23.12.1993
(51) Int. Cl.: G01P 15/08

(54) **Procédé de fabrication d'accéléromètres utilisant la technologie silicium sur isolant**
Verfahren zur Herstellung von Beschleunigungsmessern mittels der "Silizium auf Isolator"-Technologie
Method for manufacturing accelerometers using the silicon on insulator technology

(30) Priorité: 28.12.1992 FR 9215771
(43) Date de publication de la demande: 06.07.1994
(73) Titulaire: COMMISSARIAT A L'ENERGIE ATOMIQUE, 75015 Paris Cédex 15 (FR)
(72) Inventeur: Diem, Bernard, F-38130 Echirolles (FR); Delaye, Marie-Thérèse, F-38100 Grenoble (FR)
(74) Mandataire: Dubois-Chabert, Guy

(56) Documents cités:
- EP-A- 0 138 023
- EP-A- 0 198 724
- WO-A-92/22820
- DE-A- 3 741 036
- PATENT ABSTRACTS OF JAPAN vol. 16, no. 322 (E-1233) 14 Juillet 1992 & JP-A-04 094 129 (FUJITSU LTD.) 26 Mars 1992
- ELECTRONIC DESIGN vol. 39, no. 15 , 8 Août 1991 , CLEVELAND pages 45 - 56 XP261348 F.GOODENOUGH 'AIRBAGS BOOM WHEN IC ACCELEROMETER SEES 50 G'

## Description

La présente invention a pour objet un procédé de fabrication d'un accéléromètre directif à axe sensible parallèle au plan du substrat et/ou de fabrication d'un accéléromètre directif à axe sensible perpendiculaire à ce plan, utilisant la technologie silicium sur isolant.

Un accéléromètre est un capteur d'accélération comportant pour l'essentiel une masse mobile m et des moyens pour mesurer la force F=mγ due à l'accélération γ d'un corps en mouvement sur lequel l'accéléromètre est monté.

L'accélération est aujourd'hui un paramètre qu'il est de plus en plus utile et nécessaire de connaître pour les besoins industriels, notamment dans le domaine spatial et aéronautique, mais aussi pour des applications grand public comme l'automobile pour le contrôle de suspension active ou de ballons gonflables de sécurité (air-bag en terminologie anglo-saxonne).

Le développement de ces dernières utilisations nécessite une diminution très importante des coûts de fabrication, tout en conservant des qualités métrologiques acceptables des capteurs.

De façon générale, les accéléromètres de l'invention sont utilisables dans tous les domaines où l'on souhaite mesurer l'accélération d'un corps en mouvement selon une ou deux directions parallèles au substrat et/ou une direction perpendiculaire à ce substrat.

De nombreuses techniques ont été proposées pour réaliser des accéléromètres ou des structures mécaniques pour accéléromètres en silicium micro-usiné utilisant les technologies de la microélectronique.

L'avantage principal du silicium est évidemment le traitement collectif des structures et leur miniaturisation, donc un prix de revient relativement bas, mais aussi la fiabilité mécanique du matériau monocristallin ne présentant ni fluage, ni hystérésis, ni dérive dans le temps. Cette réduction importante des coûts permet une utilisation encore plus large de ces capteurs, tout en conservant des qualités métrologiques acceptables.

On distingue deux familles principales de capteurs d'accélération suivant la position de l'axe sensible par rapport au substrat semi-conducteur :
- les structures à axe sensible perpendiculaire au substrat (dénommées ci-après "structures à axe perpendiculaire") qui sont les plus développées et qui utilisent les technologies conventionnelles d'usinage chimique anisotrope en volume du silicium, c'est-à-dire que toute l'épaisseur du substrat est gravée pour libérer une structure monocristalline ;
- les structures à axe sensible parallèle au substrat (dénommées ci-après "structure à axe parallèle"), dont l'avantage principal est la possibilité d'intégrer sur la même puce des accéléromètres sensibles à deux axes coplanaires, éventuellement perpendiculaires ; ces structures utilisent une technologie de volume ou de surface.

La référence 1 - Sensors and actuators, A21-A23 (1990), p. 297-302, "Precision accelerometers with ug resolution" de R. Rudolf et al. décrit la fabrication d'accéléromètres à "axe perpendiculaire" utilisant cette technique de volume.

Un capteur à "axe parallèle" utilisant cette technique de volume est décrit dans la référence 2 - Transducers' 91 Digest of Technical papers, juin 1991, San Francisco, "A simple, high performance piezoresistive accelerometer" de J.T. Suminto, p. 104-107 - et dans la référence 3 - US-A-4 653 326 déposé au nom du demandeur.

Pour une technologie de volume, les inconvénients majeurs que l'on peut citer sont : l'utilisation d'une technique double face (machines spécifiques peu nombreuses et chères et substrats polis sur deux faces) ; une forme du capteur liée à l'orientation cristalline du substrat et donc une limitation de ces formes ; une miniaturisation du capteur limitée par l'épaisseur du substrat (structure en trois dimensions dont une dimension est fixée), et la nécessité de réaliser un scellement du capteur sur un ou plusieurs substrats nécessitant l'emploi de cavités de référence et de support de structure compliquant quelque peu la fabrication de ces capteurs.

D'une manière générale, le principe de base mis en jeu dans les capteurs d'accélération en silicium est la mesure du déplacement ou de la force exercée par une masse sismique accrochée à un support par une liaison mécanique souple, appelée poutre flexible.

La qualité première d'un accéléromètre est sa directivité ; celle-ci est obtenue par l'anisotropie de forme des poutres supports de masse. Ces poutres plus ou moins longues, de section rectangulaire, ont une grande souplesse suivant leur épaisseur et une rigidité importante suivant la largeur.

La maîtrise de l'épaisseur des poutres qui déterminera la sensibilité du capteur est la difficulté principale de fabrication du capteur.

Pour des raisons de résistance mécanique et aussi de caractéristique électrique, il est très important que les supports et la structure dégagée (masse) soient en silicium monocristallin (du fait de l'absence de fluage, hystérésis, élasticité et de la possibilité d'implantation de composants électroniques ...).

Dans le cas d'un capteur à "axe parallèle", la forme des poutres est obtenue par gravure d'un substrat silicium d'orientation particulière 110, pour lequel les plans d'attaque lents (111) sont perpendiculaires au plan du substrat (voir référence 2).

Dans ce cas, il s'agit d'une gravure anisotrope permettant d'obtenir une bonne définition géométrique mais qui conduit à une limitation des formes suivant l'orientation cristalline du substrat. En outre, elle implique des substrats spéciaux (polis sur deux faces opposées) et l'utilisation d'une technique d'alignement double face.

De plus, ces substrats non standards en microélectronique empêchent l'intégration sur le même substrat de l'électronique associée.

L'épaisseur importante du substrat en silicium à graver (environ 500µm) nécessite l'emploi de masques de gravure très sélectifs et des motifs gravés finaux relativement importants ne permettant pas une miniaturisation poussée.

Lorsque l'élément sensible est terminé, il est ensuite nécessaire de le sceller sur un ou plusieurs supports épais et rigides pour obtenir un capteur. Ce ou ces supports sont en général de nature différente de celle du substrat (par exemple en verre), ce qui conduit à des contraintes différentielles préjudiciables aux performances du capteur et à une étape délicate supplémentaire à réaliser.

D'autres techniques ont été proposées pour réaliser des capteurs à "axe parallèle" en technologie simple face (avec toutes les étapes en face avant) utilisant une couche sacrificielle avec des formes géométriques très petites et une liberté sur celles-ci.

Elles offrent en outre la possibilité d'intégrer deux capteurs à "axes parallèles" sur un même substrat.

Ainsi, un capteur d'accélération à "axe parallèle" avec son électronique intégrée a récemment été commercialisé et fabriqué selon une technique d'usinage de surface en utilisant une couche sacrificielle et une couche déposée de silicium polycristallin réalisant la structure mécanique désirée.

Ce capteur est décrit dans la référence 4 - Electronic design, août 1991, p. 45-56, "Accelerometer's micromachined mass "moves" in plane of IC ; on-chip circuit controls it and senses G with force-balance techniques" de F. Goodenough -.

Les limitations principales de cette technique de surface sont les qualités mécaniques médiocres du matériau polycristallin et les contraintes thermiques différentielles importantes induites par l'utilisation de deux matériaux différents (substrat en Si monocristallin et structure en Si polycristallin), qui conduisent à des capteurs aux qualités métrologiques limitées voir insuffisantes, ainsi que l'épaisseur limitée à quelques micromètres pour la couche de silicium polycristallin constituant la masse sismique, ce qui diminue la directivité, les possibilités du dimensionnement et les gammes de mesure du capteur.

En outre, la structure mécanique mobile en silicium polycristallin entraîne une diminution des qualités métrologiques, de reproductibilité et de stabilité du capteur.

Par ailleurs, ce capteur à "axe parallèle" présente un rapport de forme des poutres (hauteur/largeur proche de 1) peu avantageux en terme de directivité et donc une sensibilité importante aux accélérations transverses. C'est l'emploi du silicium polycristallin dont l'épaisseur du dépôt n'excède pas quelques micromètres (<2µm en général) qui limite la directivité et l'importance de la masse sismique, et par conséquent les gammes de mesures.

Par ailleurs, pour la fabrication de capteurs d'accélération en silicium à "axe perpendiculaire", les supports de la masse sismique sont très souvent réalisés par une technique d'arrêt de gravure. On utilise alors, soit la gravure d'un substrat massif de silicium par la face arrière avec arrêt sur une couche épitaxiée de silicium fortement dopé au bore (voir la référence 5 - J. Electrochem. Soc., vol. 137, n°11, novembre 1990, "Anisotropic etching of crystalline silicon in alkaline solutions : II. Influence of dopants" de H. Seidel et al., p. 3626-3632 -), soit une gravure électrochimique du substrat en silicium avec arrêt de l'attaque sur une couche de silicium épitaxiée formant une jonction P/N avec le substrat (voir la référence 6 - IEEE Transactions on Electron Devices, vol. 36, N°4, avril 1989, "Study of electrochemical etch-stop for high-precision thickness control of silicon membranes" de B. Kloeck et al., p. 663-669 -).

Ces deux techniques d'arrêt de gravure présentent les inconvénients mentionnés ci-dessus. En effet, elles utilisent une gravure anisotrope du substrat, limitant les formes des éléments sensibles du fait de l'orientation cristalline du substrat, ainsi qu'une attaque par face arrière nécessitant l'emploi de substrats spéciaux et l'utilisation d'une technique d'alignement double face.

Par ailleurs, ces techniques d'arrêt nécessitent l'emploi de masques de gravure très sélectifs et, compte tenu des plans d'attaque inclinés (54,7° pour le silicium d'orientation 100), et de l'épaisseur du silicium à graver, les formes réalisées sur la face arrière sont très supérieures aux formes utiles finales du composant.

D'autres techniques ont été proposées pour réaliser des capteurs à "axe perpendiculaire" en utilisant la technologie de surface. Ces techniques sont décrites notamment dans la référence 7 - Sensors and Actuators, A21-A23 (1990), p.273-277, "Monolithic silicon accelerometer" de B. Boxenhorn et P. Greiff -. Cette solution présente l'inconvénient d'utiliser une structure en silicium fortement dopé, de l'ordre de 10²⁰At/cm³, ce qui diminue les qualités métrologiques du capteur. En outre, ce capteur travaille en torsion.

Pour remédier à ces différents inconvénients, l'invention propose un procédé de fabrication d'un accéléromètre à axe sensible parallèle au substrat ou à axe sensible perpendiculaire au substrat, utilisant la technologie silicium/isolant, associée à un micro-usinage de surface.

La technologie silicium/isolant est connue sous l'abréviation SOI. L'une des techniques connues fait appel à la recristallisation par laser d'une couche de silicium amorphe ou polycristallin, déposée sur une couche d'oxyde de silicium obtenue par oxydation thermique d'un substrat de silicium monocristallin. Une seconde technique connue sous l'abréviation SDB consiste à réaliser le scellement de deux substrats en silicium dont un au moins possède sur la surface de scellement une couche de SiO₂ obtenue par exemple par oxydation thermique et à amincir ensuite un des deux substrats jusqu'à une épaisseur désirée (voir Technical Digest MNE'90, 2nd Workshop, Berlin, novembre 90, p. 81-86 de C. Harendt et al., "Wafer bonding and its application to silicon-on-insulator fabrication".

Une troisième technique connue est basée sur l'implantation d'ions oxygène ou d'azote à forte dose dans du silicium monocristallin massif qui, après recuit du substrat à haute température, conduit à la formation d'une couche isolante enterrée d'oxyde de silicium ou de nitrure de silicium supportant un film de silicium monocristallin. La technologie à implantation d'ions oxygène est connue sous la terminologie SIMOX.

L'invention s'applique à ces différentes techniques SOI.

Le procédé de l'invention permet l'obtention de structures mécaniques en silicium monocristallin et donc de bonnes qualités métrologiques, de dimensions très petites et donc de densité élevée, abaissant ainsi le coût de fabrication. Ce procédé permet de plus de réaliser des capteurs d'accélération à axe sensible perpendiculaire ou parallèle au plan du substrat, qui peuvent être asservis, assurant ainsi une réponse linéaire, ou auto-testables pour le calibrage, avec une directivité élevée.

Par ailleurs, le procédé de l'invention permet la fabrication monolithique et collective de micro-accéléromètres avec toute liberté sur la forme de la structure, en utilisant une technologie simple face et des substrats silicium standards, polis sur une face et d'épaisseur standard, présentant un encombrement très faible.

En outre, ce procédé permet de supprimer l'étape critique de scellement du capteur sur un support de nature différente ainsi que d'obtenir un prix de revient très bas pour chaque accéléromètre.

Enfin, l'invention permet l'intégration sur un même substrat et la fabrication simultanée d'un ou plusieurs accéléromètres à axe sensible parallèle au substrat et d'un ou plusieurs accéléromètres à axe sensible perpendiculaire au substrat.

De façon plus précise, l'invention a pour objet un procédé de fabrication d'un accéléromètre intégré comportant des éléments mobiles, caractérisé en ce qu'il comprend les étapes suivantes :
a) - réalisation d'un film de silicium monocristallin sur un substrat en silicium et séparé de ce dernier par une couche isolante ;
b) - gravure du film de silicium et de la couche isolante jusqu'au substrat pour fixer la forme des éléments mobiles ; et
c) - élimination partielle de la couche isolante pour dégager les éléments mobiles, le restant de la couche isolante rendant les éléments mobiles et le substrat solidaires.

Ce procédé s'applique aussi bien à la fabrication d'un accéléromètre à axe sensible parallèle au substrat qu'à un accéléromètre à axe sensible perpendiculaire au substrat.

Les moyens de détection des déplacements éventuels des éléments mobiles peuvent être intégrés ou non à la structure sensible. Lorsque ces moyens sont intégrés, ils sont réalisés en surface du film de silicium et définis en partie au cours de l'étape b). Dans ce cas, le film de silicium est avantageusement conducteur et une étape supplémentaire de fabrication de contacts électrique sur ce film doit être prévue.

Avantageusement, on utilise comme moyens de détection des éventuels déplacements des éléments mobiles, des condensateurs. D'autres systèmes de mesure de ces déplacements tels que des moyens inductifs ou piézoélectriques peuvent toutefois être envisagés.

Ces condensateurs sont réalisés à l'aide d'une ou plusieurs électrodes de surface isolées électriquement du substrat.

Le procédé de l'invention comporte une étape supplémentaire d'épitaxie d'une couche de silicium monocristallin conducteur sur la structure obtenue en b) en vue d'épaissir ladite structure. Cette épitaxie est effectuée au moins à l'emplacement des éléments mobiles. Elle assure une rigidité et augmente la masse sismique de l'accéléromètre.

Ce silicium épitaxié doit en outre être dopé afin d'assurer une conductivité électrique suffisante de l'accéléromètre et donc une bonne détection des éventuels déplacements des éléments mobiles.

Le procédé de l'invention s'applique à toutes les techniques de silicium/isolant citées précédemment. Cependant, de façon avantageuse, l'étape a) consiste à implanter des ions d'oxygène dans un substrat en silicium monocristallin conducteur et à recuire le substrat implanté.

L'implantation d'ions peut avoir lieu en une ou plusieurs fois, chaque implantation étant suivie du recuit de la structure.

Le film de silicium et éventuellement le substrat lorsque ce dernier est à l'origine de la fabrication du film de surface peuvent présenter une conductivité N. Il est toutefois préférable d'utiliser une conductivité P.

Les éléments mobiles consistent en une ou plusieurs poutres flexibles soutenant une masse sismique, dont l'une des extrémités est solidaire du substrat mais isolée électriquement de ce dernier.

Afin de faciliter l'élimination partielle de la couche d'isolant, on effectue des ouvertures dans la masse sismique de l'accéléromètre, définie dans le film de silicium, s'arrêtant sur cette couche isolante. Cette étape est réalisée juste avant l'étape d'élimination de la couche d'isolant.

Comme indiqué précédemment, le procédé de l'invention s'applique aussi bien à la fabrication d'un accéléromètre à axe sensible parallèle à la surface du au substrat qu'à celle d'un accéléromètre à axe sensible perpendiculaire à cette surface.

Dans le cas d'un accéléromètre à éléments mobiles selon une direction parallèle au substrat, le procédé de l'invention comprend avantageusement une étape de gravure du film de silicium et de la couche d'isolant pour former un écran électrostatique en forme de peigne qui constitue une partie des moyens de mesure des éventuels déplacements de ces éléments mobiles.

Pour la fabrication d'un accéléromètre à axe sensible parallèle au substrat, comportant au moins une poutre supportant une masse sismique, la poutre et la masse étant mobiles selon une direction parallèle au substrat, le procédé de l'invention comporte avantageusement les étapes successives suivantes :
1) - implanter des ions oxygène dans un substrat en silicium monocristallin conducteur, puis recuire le substrat implanté, formant ainsi une couche d'oxyde enterrée séparant le film de silicium conducteur du substrat ;
2) - graver l'empilement film-couche d'oxyde jusqu'au substrat pour former la masse mobile, la poutre et une partie des moyens de mesure ;
3) - épitaxier une couche de silicium conducteur sur toute la structure obtenue en 2) pour épaissir la masse mobile et la poutre ;
4) - réaliser des contacts métalliques sur les moyens de mesure ;
5) - graver la couche épitaxiée et le film de silicium jusqu'à la couche d'oxyde pour former des trous dans la masse mobile et un écran électrostatique en forme de peigne constituant en partie les moyens de mesure ;
6) - éliminer partiellement la couche d'oxyde.

L'invention a aussi pour objet un procédé de fabrication d'un accéléromètre à éléments mobiles selon une direction perpendiculaire au substrat comportant avantageusement une étape de fabrication d'une électrode enterrée dans le substrat monocristallin et une étape de prise de contact sur cette électrode enterrée.

Cette électrode enterrée peut être formée en implantant localement des ions dans le substrat présentant une conductivité inverse de celle du substrat.

Ainsi, pour un substrat de type N on effectue une implantation d'ions de type P de façon à former une jonction P/N.

La masse mobile devant être supportée par une ou plusieurs poutres réalisées dans le film de silicium, il est important que ces poutres flexibles soient mécaniquement en tension dans le cas d'un accéléromètre à "axe perpendiculaire". Aussi, il est préférable d'effectuer un dopage par exemple par implantation d'ions de type P sur toute la surface du film de silicium, pour un film de type N. Cette implantation crée une contrainte en tension de la ou des poutres flexibles.

Le procédé de l'invention comprend, dans le cas d'un accéléromètre à "axe perpendiculaire", une étape de réalisation d'une électrode de surface sur le film de silicium, le dépôt et la gravure d'une couche additionnelle d'isolant pour isoler électriquement le substrat de cette électrode de surface, afin d'assurer une détection capacitive.

Avantageusement, l'électrode de surface est réalisée en silicium polycristallin conducteur. Cette électrode peut être de type N ou P.

Le procédé de l'invention permet la fabrication d'un accéléromètre à "axe perpendiculaire" comportant au moins une poutre supportant une masse sismique, mobiles selon une direction perpendiculaire au substrat, au moins une électrode de surface et au moins une électrode enterrée. Dans ce cas, ce procédé comprend les étapes successives suivantes :
i) - implanter des ions oxygène dans un substrat en silicium monocristallin conducteur d'un premier type de conductivité, puis recuire le substrat implanté, formant ainsi une couche d'oxyde enterrée séparant le film de silicium conducteur du substrat ;
ii) - former une électrode enterrée dans le substrat ;
iii) - graver l'empilement film-couche d'oxyde jusqu'au substrat pour former la masse mobile, la poutre et une prise de contact sur l'électrode enterrée ;
iv) - former des plots sur la masse mobile et sur la poutre, éliminables sélectivement par rapport au silicium ;
v) - isoler électriquement la structure obtenue en iv) à l'emplacement prévu pour l'électrode de surface par un isolant électrique additionnel ;
vi) - épitaxier une couche de silicium monocristallin conducteur sur la masse pour l'épaissir et déposer du silicium polycristallin à l'emplacement prévu pour l'électrode de surface ;
vii) - réaliser des contacts métalliques pour l'électrode de surface et l'électrode enterrée ;
viii) - graver l'empilement silicium épitaxié-film de silicium jusqu'à l'oxyde pour former des ouvertures dans la masse mobile ;
ix) - éliminer les plots et partiellement la couche d'oxyde.

Afin d'éliminer les plots isolants et la couche d'oxyde simultanément, ces plots sont avantageusement réalisés en oxyde de silicium.

Le procédé de l'invention permet la réalisation simultanée sur un même substrat semiconducteur d'un ou plusieurs accéléromètres à éléments mobiles selon une direction parallèle au substrat et d'un ou plusieurs accéléromètres à éléments mobiles perpendiculaires au substrat. Dans ce cas, les étapes spécifiques à la réalisation des accéléromètres à éléments mobiles selon une direction perpendiculaire au substrat, et notamment les étapes ii), iv), v) sont effectuées en masquant les régions du substrat destinées à la fabrication des accéléromètres à axe sensible parallèle au substrat.

D'autres caractéristiques et avantages de l'invention ressortiront mieux de la description qui va suivre, donnée à titre illustratif et non limitatif, en référence aux dessins annexés, dans lesquels :
- la figure 1 représente schématiquement en vue de dessus un accéléromètre à axe sensible parallèle au substrat, fabriqué selon le procédé de l'invention,
- la figure 2 est une vue en coupe selon la direction II-II de la figure 1,
- la figure 3 est une vue en coupe selon la ligne III- III de la figure 1,
- les figures 4 à 8 illustrent schématiquement les différentes étapes de fabrication conformément à l'invention de l'accéléromètre de la figure 1 : les figures 4, 5, 6 et 8 étant des coupes selon la direction II-II de la figure 1 et la figure 7 étant une coupe selon la direction III-III de la figure 1,
- la figure 9 est une vue de dessus d'un accéléromètre à axe sensible perpendiculaire au substrat, fabriqué selon le procédé conforme à l'invention,
- la figure 10 est une vue en coupe selon la direction X-X de la figure 9,
- les figures 11A, 11B, 12, 13A, 14B, 14A, 14B, 15A, 15B, 16A, 16B, 17A et 17B illustrent les différentes étapes de fabrication de l'accéléromètre des figures 9 et 10 : les figures 11B, 12, 13B, 14B, 15B, 16B et 17B sont des vues en coupe alors que les figures 11A, 13A, 14A, 15A, 16A et 17A sont des vues de dessus, et
- la figure 18 illustre, en coupe, le principe d'un accéléromètre.

La description qui suit sera faite en utilisant la technique SIMOX ainsi que l'emploi d'un substrat monocristallin de type N, mais comme on la vu précédemment, d'autres techniques de silicium/isolant ainsi que l'emploi d'un substrat de type P peuvent être envisagés.

### 1°) - Accéléromètre à axe sensible parallèle au substrat.

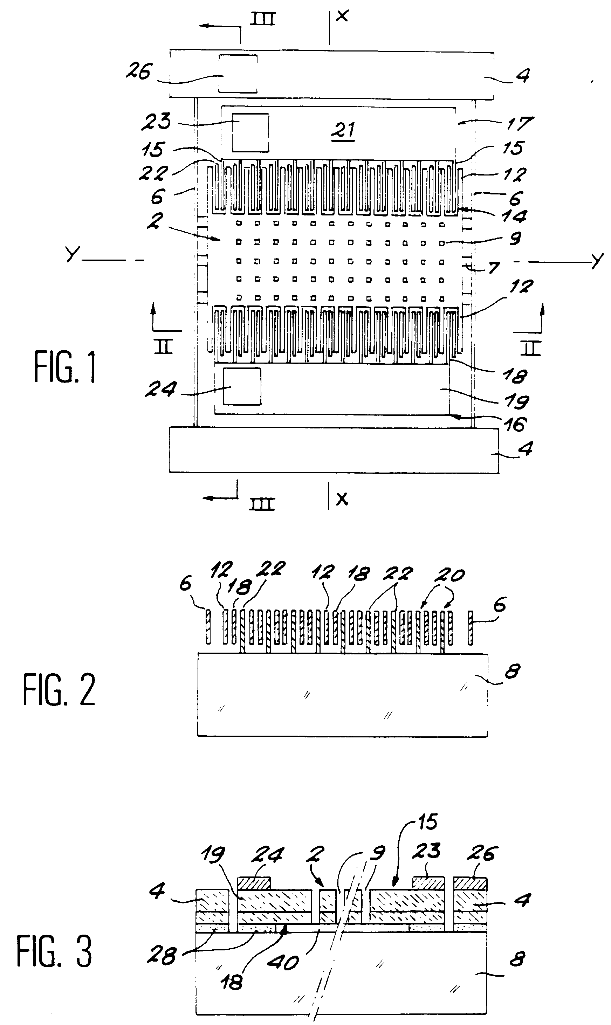

En se référant aux figures 1, 2 et 3, on décrit ci-après la réalisation d'un exemple particulier d'un accéléromètre à axe sensible parallèle au substrat.

Cet accéléromètre comprend une masse sismique 2 mobile en silicium monocristallin dopé P, reliée par des poutres flexibles 6 à des éléments supports fixes 4. Cette masse 2 comporte des trous traversants 9 et des parties en saillie 7 assurant sa liaison avec les poutres. L'intérêt de ces trous apparaîtra ultérieurement.

Les éléments 4 sont solidaires et isolés d'un substrat 8.

Les éléments 4 et les poutres 6 sont en silicium monocristallin de type P alors que le substrat 8 est en silicium monocristallin de type N.

Sur la figure 1, l'accéléromètre comporte deux éléments supports 4 de part et d'autre de la masse sismique 2, reliés par deux poutres 6 orientées perpendiculairement aux éléments 4. Cette structure est donc symétrique par rapport à deux axes X et Y perpendiculaires, situés parallèlement à la surface du substrat 8.

Il est cependant possible de réaliser un accéléromètre ne comportant que le quart supérieur gauche de la structure, qui fonctionne aussi.

La masse sismique 2 de l'accéléromètre de la figure 1 comporte de part et d'autre de l'axe Y des électrodes 12 en forme de dents, orientées parallèlement à la direction X ; elles constituent deux premiers peignes 14 mobiles. En regard de chaque premier peigne 14 et décalé, on trouve un second peigne fixe 16 ou 17 dont les dents 18 ou 15 jouant le rôle d'électrodes sont parallèles à la direction X et encastrées entre les dents 12 du peigne 14. Ces peignes 16 et 17 sont aussi en silicium monocristallin dopé P et sont solidaires du substrat 8 par leur partie massive 19 et 21 (figure 3).

Les dents 12 et 18 ou 15, du fait de leur propriété conductrice, constituent des armatures de condensateurs à capacité variable. En effet, lorsque les poutres 6 se déplacent parallèlement au substrat 8 selon la direction Y, les dents 12 mobiles se déplacent selon cette direction Y alors que les dents 18 et 15 restent fixes modifiant ainsi l'espace séparant une dent 12 de la dent 18 ou 15 en regard et donc la capacité du condensateur correspondant.

La variation de la capacité de chaque condensateur est proportionnelle au déplacement selon la direction Y. Ainsi, en mesurant cette variation de capacité, il est possible de connaître le déplacement des poutres dans la direction Y.

A chaque dent 12, hormis celles des extrémités latérales, correspond deux capacités variables variant en sens inverse.

Aussi, afin de n'associer qu'une seule valeur de capacité pour chaque dent 12 et du fait de la symétrie par rapport à la direction Y, deux écrans électrostatiques 20 constitués essentiellement de dents 22 parallèles à la direction Y sont prévus de part et d'autre de cette direction ; chaque dent 22 est intercalée entre une dent mobile 12 et une dent fixe 18 ou 15.

Chaque écran électrostatique est réalisé en un matériau conducteur de l'électricité et par exemple en silicium monocristallin dopé P de préférence et en même temps que la masse, les poutres 6 et les électrodes 18 et 15.

Comme représenté sur la figure 2, les électrodes 22 fixes des écrans électrostatiques sont au contact direct du substrat 8 et donc reliées électriquement à ce dernier. En revanche, comme représenté sur la figure 3, les éléments supports 4 des poutres 6 et les parties massives 19 et 21 des peignes fixes 16 et 17 sont isolés électriquement du substrat 8 par une couche d'oxyde de silicium 28 gravée.

La masse sismique 2 est quant à elle suspendue au-dessus du substrat 8. La référence 40 indique l'espace vide séparant la masse 2 du substrat 8.

L'agencement des électrodes ou dents 12 et 18 ou 15 et des écrans électrostatiques 20 permet une mesure différentielle des déplacements de la masse 2 supportée par les poutres 6 selon la direction Y ainsi qu'un asservissement de la mesure.

Afin de mesurer les variations de capacité des condensateurs 12-18, un contact électrique 23 ou 24 de référence est prévu sur les peignes respectivement 17 ou 16. En outre, un contact électrique de mesure 26 est prévu sur l'un des éléments de support 4 afin d'assurer la mesure différentielle.

Sous l'effet d'une accélération selon la direction Y, la masse sismique 2 est soumise à une force (F=mγ) qui la fait se déplacer suivant la raideur des poutres 6 d'une distance 1 parallèle à Y. Les capacités mesurées entre ces électrodes 12 solidaires de la masse sismique 2 et les électrodes fixes 18 et 15 (qui servent de butées en cas de surcharge) des peignes 16, 17 et 14 "interdigités" vont varier de façon opposée.

L'interposition d'une électrode 22 d'un écran électrostatique 20 entre une face d'une électrode fixe 18 ou 15 et une face d'une électrode mobile 12 permet d'associer un seul condensateur de capacité variable à chaque dent mobile et donc d'annuler l'effet de capacité parasite.

Electriquement, les trois séries d'électrodes 12, 18 ou 15, 22 sont isolées et sous l'effet d'un champ électrique E appliqué entre la masse sismique 2, via le contact 26, et une des deux électrodes 18 ou 15, respectivement via le contact 24 ou 23, une force électrostatique d'attraction est créée.

Pour un asservissement de la mesure, on utilise un dispositif de mesure connecté entre les contacts 24 ou 23 et 26 qui détecte la variation de capacité différentielle induite par le déplacement de la masse sismique selon Y lors d'une accélération. Ce dispositif du type capacimètre produit un signal de mesure alternatif de faible amplitude.

On superpose alors à celui-ci une polarisation continue appliquée, via les contacts 24 ou 23 et 26, entre les électrodes 12 et 18 ou 15 (qui voient leur capacité diminuer) permettant d'exercer une force (d'origine électrostatique) égale à celle créée par l'accélération selon Y et qui ramène la masse à sa position d'équilibre et donc à la capacité initiale de chaque condensateur variable.

Cette polarisation est donc l'image de l'accélération selon Y et permet d'obtenir un capteur de très grande linéarité ainsi que de l'utiliser pour un autotest de la structure.

Pour mesurer indépendamment une accélération selon une direction X, il suffit de former sur le même substrat 8 un accéléromètre tel que celui représenté sur les figures 1 à 3 mais en l'orientant selon une direction perpendiculaire de sorte que les poutres 6, les dents 12, 18 et 22 soient orientées parallèlement à Y. Dans ce cas, on peut détecter une accélération selon la direction X par déplacement de la masse sismique parallèlement à X.

### 2°) - Fabrication de l'accéléromètre à axe sensible parallèle au substrat.

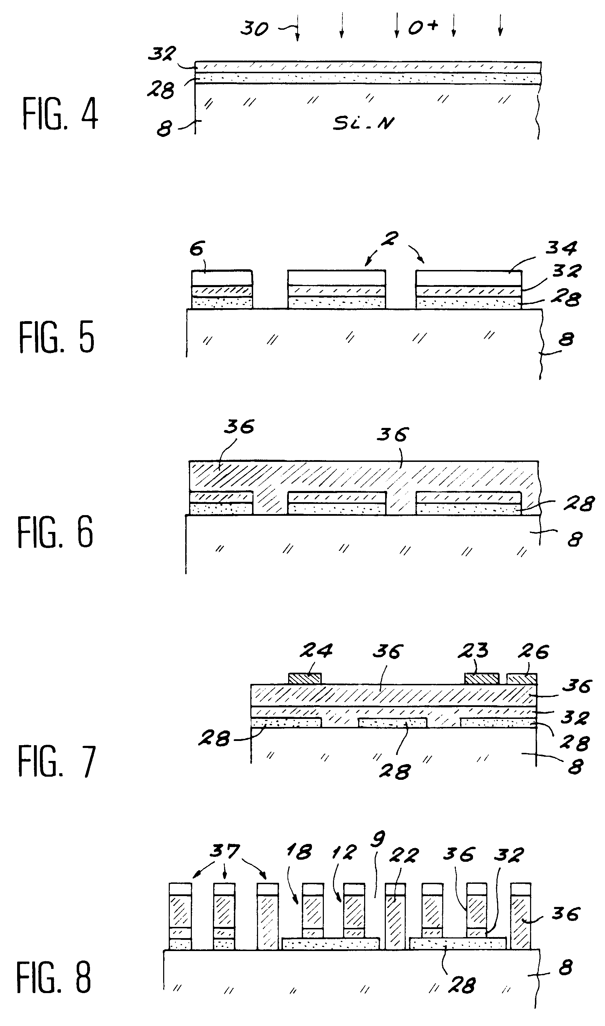

La première étape du procédé, représentée sur la figure 4, consiste à former un empilement du type silicium/isolant sur le substrat 8. A cet effet, on implante des ions oxygène 30 (O+ ou O₂+) dans le substrat 8 monocristallin dopé N d'orientation quelconque (100, 110, 101), à une dose de 10¹⁶ à 10¹⁸ ions/cm², puis on recuit la structure implantée à une température allant de 1150°C à 1400°C.

Cette implantation d'oxygène et ce recuit peuvent être répétés plusieurs fois. L'énergie d'implantation est choisie entre 100 et 1000KeV.

Cette mono- ou multi-implantation suivie de son recuit permet l'obtention d'une couche d'oxyde 28 homogène enterrée sur toute la surface du substrat 8 et une couche superficielle 32 de silicium monocristallin N.

A titre d'exemple, l'épaisseur de la couche 28 de SiO₂ est d'environ 400nm et celle de la couche superficielle 32 de silicium d'environ de 150nm en utilisant trois implantations d'oxygène à une dose de 10¹⁸ions/cm et une énergie de 200KeV.

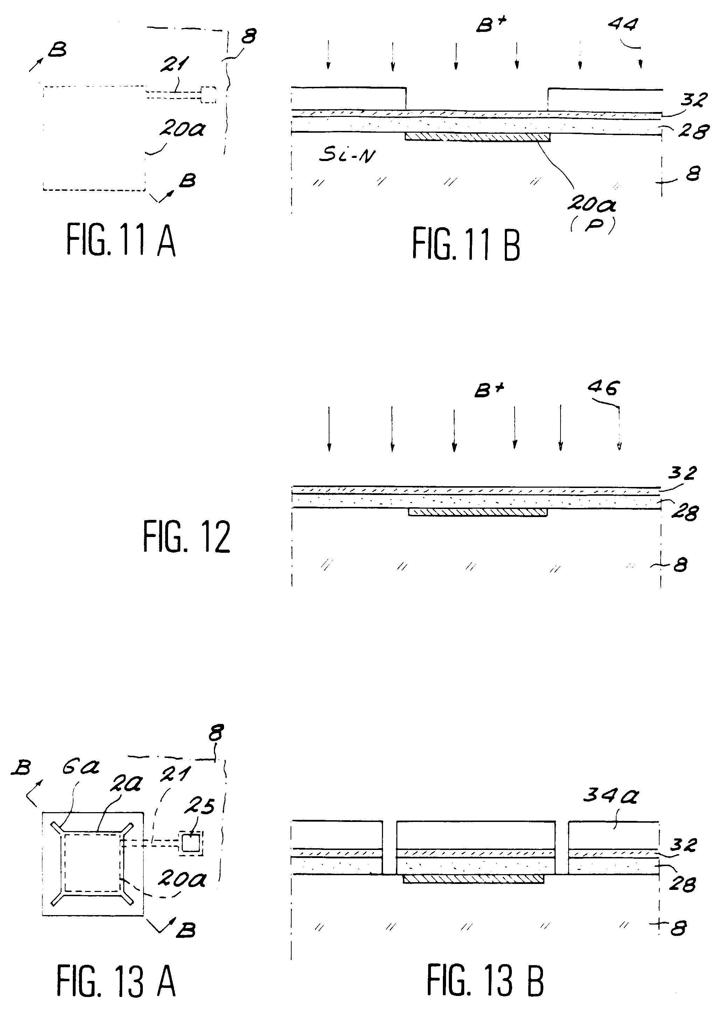

On effectue ensuite un dopage de type P de tout le film de silicium 32 pour le contraindre en tension par exemple par implantation d'ions (figure 12) de bore à une énergie relativement basse, de l'ordre de 30keV pour ne pénétrer qu'en surface du film 32, avec une dose de quelques 10¹⁴At/cm² (typiquement de 2x10¹⁴).

Dans le cas d'un substrat de départ de type P, cette implantation n'est nullement nécessaire.

L'étape suivante du procédé représentée sur la figure 5, consiste à graver les couches 32 et 28 jusqu'au substrat 8 suivant un motif voulu permettant de fixer la forme générale des écrans électrostatiques 20 et de la masse sismique 2.

Cette attaque est effectuée par gravure ionique réactive en utilisant par exemple du SF₆ et du CHF₃ pour respectivement le silicium 32 et l'oxyde 28. Cette gravure est effectuée indépendamment de l'orientation cristalline du substrat en utilisant les techniques classiques de photolithographie et notamment un masque de résine 34 représentant le motif voulu.

Après élimination du masque 34 par attaque chimique, on épitaxie sur l'ensemble de la structure une couche 36 de silicium monocristallin dopé P, sur une épaisseur de 1 à 100 µm suivant la sensibilité désirée pour l'accéléromètre (typiquement 10 à 20µm) destinée à rigidifier la structure et notamment les poutres 6, et à obtenir une masse sismique suffisante. Cette épitaxie est réalisée en phase vapeur ; la structure obtenue est celle de la figure 6.

On effectue alors le dépôt d'une couche métallique sur l'ensemble de la structure pour assurer les interconnexions avec les circuits de mesure ainsi que les prises de contact 23, 24 et 26. Cette métallisation a une épaisseur de 0,5µm environ et peut être en aluminium, en or ou un empilement multicouche du type Ti-Ni-Au et de façon générale en un métal qui peut résister lors de la gravure de l'oxyde de silicium. Avec une métallisation tricouche la couche de titane assure le contact ohmique sur le silicium, le nickel joue le rôle de barrière de diffusion et l'or assure la conduction électrique.

Cette couche de métal est alors gravée pour former les contacts 23, 24 et 26 respectivement sur les parties 19 et 21 de silicium et les éléments supports 4. Pour une métallisation tricouche, on peut utiliser une gravure chimique humide avec par exemple un mélange d'iode et d'iodure de potassium pour la gravure de l'or, du (NH₄)₂S₂O₈ dans H₂SO₄ pour graver le nickel et une solution d'H₂F à 1% en volume pour la gravure du titane. La structure obtenue après gravure est celle représentée sur la figure 7.

On effectue alors, comme représenté sur la figure 8 une gravure de la couche épitaxiée 36 puis de la couche de silicium 32 jusqu'à la couche de silice 28 et voire même jusqu'au substrat 8 au niveau de l'écran électrostatique. Cette gravure est une gravure sèche anisotrope par exemple ionique réactive utilisant un mélange de CCl₄+N₂ pour le silicium et du CHF₃ pour l'oxyde. Elle est réalisée selon les procédés classiques de photolithographie, en utilisant un masque de résine ou de SiO₂ 37 de forme appropriée.

Ce masque définit la forme des dents 22 des écrans électrostatiques, des dents 12 de la masse sismique et des dents fixes 18 et 15. De plus, cette gravure permet comme représenté sur la figure 1, la création des trous 9 dans la partie massive de la masse sismique 2 sur toute la partie en silicium (figure 3).

L'étape suivante du procédé, après élimination du masque 37, consiste à libérer les éléments mobiles de l'accéléromètre et par conséquent la masse sismique 2 équipée de ses peignes 14 ainsi que des poutres flexibles 6 par gravure de la couche de silice 28 dans une solution à base d'acide fluorhydrique à partir des bords de la structure et des trous 9. La structure obtenue est alors celle représentée sur les figures 2 et 3.

Cette gravure est réalisée partiellement de façon que les poutres 6 soient supportées par le substrat 8 tout en étant isolées de ce dernier. Les trous 9 sont pratiqués pour permettre une gravure rapide de la couche 28 enterrée sous la masse sismique 2 sans surgravure importante dans les zones que l'on ne désire pas libérer et en particulier sous les supports 4 et éléments massifs 19 et 21 des peignes 16 et 17 à électrodes fixes 18 ou 15.

On effectue ensuite un rinçage et séchage de la structure ainsi obtenue.

La technique SIMOX utilisée permet la constitution d'une couche d'oxyde 28 sacrificielle d'épaisseur homogène, qui après élimination, permet de libérer la structure en silicium monocristallin du dessus tout en réalisant un entrefer 40 (figure 3) parfaitement maîtrisé et étroit entre le substrat 8 et le silicium 32, dont le fond peut être utilisé comme butée mécanique en cas de surcharge.

### 3°) - Accéléromètre à axe sensible perpendiculaire au substrat.

Dans la suite de la description, les éléments jouant le même rôle que ceux décrits précédemment en référence aux figures 1 à 8 porteront le même numéro suivi de la lettre a. En outre, cet accéléromètre étant réalisable sur le même substrat que celui décrit précédemment et simultanément, les matériaux ainsi que leur technique de dépôt et de gravure utilisés seront donc les mêmes.

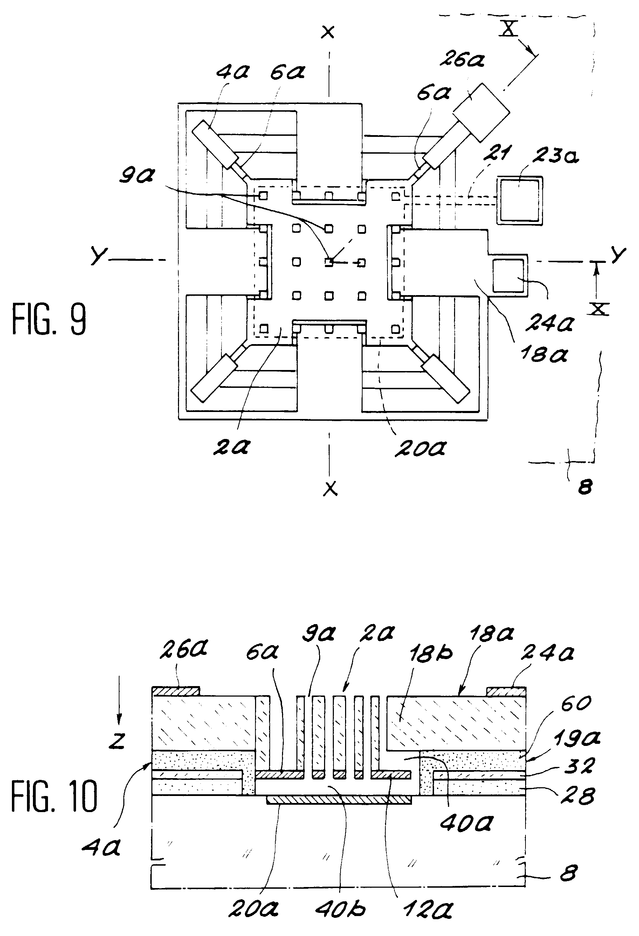

Cet accéléromètre est représenté en vue de dessus sur la figure 9 et en coupe sur la figure 10, selon la direction X-X de la figure 9.

Comme précédemment, cet accéléromètre a une configuration symétrique, mais il est possible de n'utiliser pour la détection d'une accélération selon une direction Z perpendiculaire au substrat, que le quart supérieur gauche de la structure représentée.

Cet accéléromètre comporte une masse sismique 2a, de forme carrée dans le plan XY, équipée de ses trous 9a. Cette masse sismique 2a est reliée mécaniquement par les poutres 6a à des éléments de support 4a solidaires du substrat 8 mais isolés de ce dernier par la couche d'oxyde 28.

La masse sismique 2a est équipée de membranes 12a mobiles selon la direction Z, ici au nombre de 4, et disposées sur les cotés latéraux de la masse sismique 2a. Ces membranes 12a servent d'électrodes mobiles pour la détection capacitive et l'asservissement de cette mesure. Ces membranes 12a sont réalisées comme les poutres 6a en silicium monocristallin et ont une épaisseur inférieure au micromètre, par exemple de l'ordre de 0,22µm.

De part et d'autre de ces électrodes 12a mobiles, on trouve une électrode fixe supérieure 18a dont la partie 18b en surplomb joue le rôle de butée supérieure. Ces électrodes 18a sont réalisées en silicium polycristallin dopé P.

Un espace homogène 40a séparant l'électrode 18a et l'électrode 12a est prévu. De même, un espace homogène 40b séparant l'électrode 12a et l'électrode 20a est prévu.

Ces électrodes 18a sont supportées par des éléments de support 19a isolés électriquement du substrat 8.

Au-dessus des électrodes 18a, on trouve des contacts métalliques de référence 24a et au-dessus des supports 4a des poutres des contacts métalliques 26a de mesure.

Avantageusement, bien que non nécessaire, on trouve sous la masse sismique 2a une électrode implantée enterrée 20a de type P.

L'utilisation d'une électrode enterrée 20a est une solution préférée car elle permet des mesures tout en éliminant les capacités parasites. Cependant, l'accéléromètre peut fonctionner sans cette électrode enterrée. Dans ce cas, elle est remplacée par le substrat lui-même qui est conducteur de type P.

La prise de contact sur l'électrode 20a est effectuée latéralement grâce à un lien électrique 21 implanté dans le substrat et une prise de contact métallique 23a ramenée en surface.

On décrit ci-après le fonctionnement du capteur d'accélération à axe sensible selon Z.

Sous l'effet d'une accélération selon Z, la masse sismique 2a est soumise à une force (F=mγ) qui la fait se déplacer suivant la raideur des poutres 6a d'une distance l parallèle à Z. Les capacités mesurées entre les électrodes 12a solidaires de la masse sismique et les électrodes constituées par les butées 18b supérieures et le substrat 8 vont varier de façon opposée.

Electriquement, les trois types d'électrodes 12a, 18b et 20a sont isolés et sous l'effet d'un champ électrique E appliqué entre la masse sismique 2a, via le contact 26a, et une des deux électrodes 18b ou 20a, via respectivement le contact 24a et 23a, une force électrostatique d'attraction est créée.

Pour un asservissement, on utilise encore un dispositif de mesure connecté sur les contacts 24a, 23a et 26a qui détecte la variation de capacité différentielle induite par le déplacement de la masse sismique selon Z lors d'une accélération.

Ce dispositif produit comme précédemment un signal de mesure alternatif de faible amplitude que l'on superpose à une polarisation continue appliquée sur les électrodes 12a et 18b via les contacts électriques 24a, 26a correspondants créant une force égale à celle créée par l'accélération selon Z et qui ramène la masse à sa position d'équilibre.

### 4°) - Fabrication de l'accéléromètre à axe sensible selon une direction perpendiculaire au substrat.

La première étape représentée sur la figure 11 consiste à réaliser l'empilement de silicium monocristallin 32 et de couche d'oxyde 28 sur le substrat 8 de type N de la même façon que décrit en référence à la figure 4.

L'étape suivante représentée sur les figures 11a et 11b concerne la fabrication d'une électrode enterrée dans le substrat 8. A cet effet, on forme un masque photolithographique 42 par les procédés classiques fixant l'image de l'électrode 20a à réaliser dans le substrat ainsi que sa liaison électrique 21, en dehors de la zone sensible de l'accéléromètre, en vue d'une prise de contact ultérieure.

A travers le masque 42, on réalise une implantation 44 profonde de bore à haute énergie, sous la couche d'oxyde enterrée 28. Les conditions d'implantation peuvent être par exemple une dose de 5x10¹⁴At/cm² à une énergie de 240keV afin d'obtenir une zone dopée de type P de bonne conductivité électrique et d'épaisseur d'environ 0,3µm juste au-dessous de la couche enterrée 28 et ce, dans la zone non masquée par la résine 42. Ce dernier devra être suffisamment épais afin de bloquer l'implantation sur les zones non désirées. Une épaisseur de 2µm par exemple de résine photosensible pourra être utilisée.

Cette implantation réalisée, on enlève le masque 42 par exemple par attaque chimique.

La structure mobile 2a devant être supportée par des poutres 6a réalisées dans le film mince de silicium 32, il est important que ces supports flexibles soient mécaniquement en tension. Cette contrainte en tension peut être obtenue lorsque le silicium est de type P. Le film de silicium 32 étant de type N, du fait du choix de départ du substrat 8, il est alors nécessaire de la doper P. Ce dopage est réalisé, comme représenté sur la figure 12, en implantant des ions de type P sur toute la surface du film de silicium 32.

Cette implantation 46 peut être réalisée avec des ions de bore dans les conditions décrites précédemment.

L'étape suivante du procédé, représentée sur les figures 13A et 13B, consiste à graver l'empilement de film de silicium 32 et de couche d'oxyde 28 jusqu'au substrat 8 en utilisant un masque 34a de forme appropriée. Ce masque 34a fixe en particulier les formes de la masse sismique 2a, des poutres 6a et celle du trou de contact 25 pour prise de contact ultérieure sur l'électrode enterrée 20a.

Cette gravure de l'empilement bicouche est réalisée dans les mêmes conditions que celles décrites en référence à la figure 5.

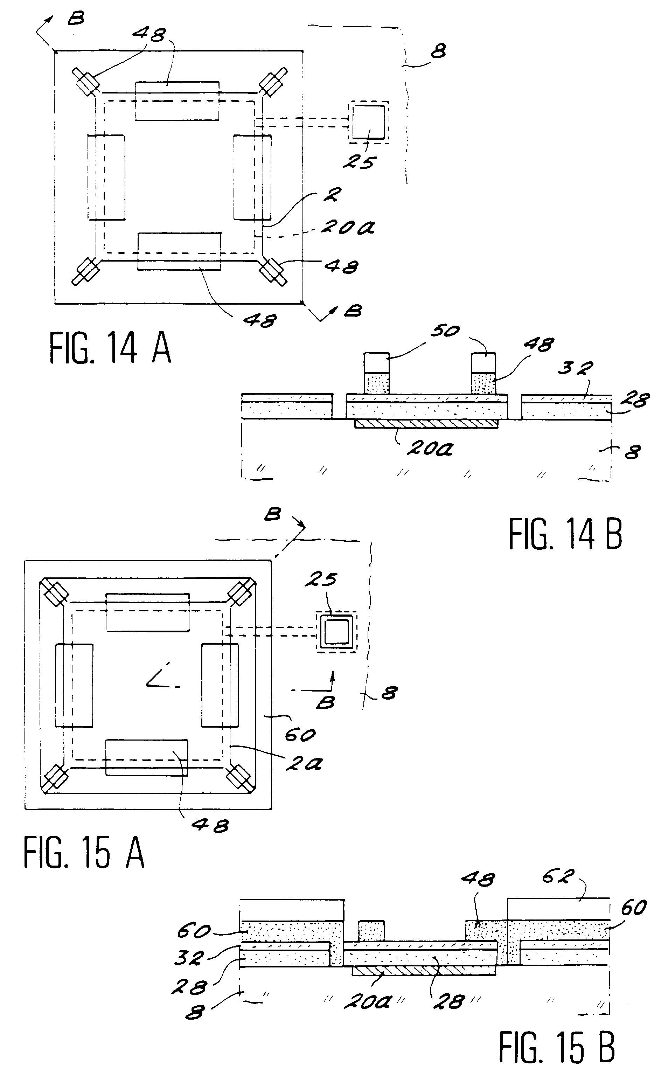

L'étape suivante du procédé est représentée sur les figures 14A et 14B. Elle consiste à déposer sur l'ensemble de la structure une couche d'isolant 48, par exemple en SiO₂ d'une épaisseur généralement égale à celle de l'oxyde enterré 28. Cet oxyde 48 est gravé selon les procédés classiques de photolithographie en utilisant un masque 50. Cette couche 48 peut être déposée selon la technique de dépôt chimique en phase vapeur assisté plasma (PECVD) puis être gravée par exemple par voie chimique en utilisant une solution d'acide fluorhydrique ou par gravure sèche (GIR) avec du CHF₃.

La couche 48 gravée est destinée à protéger les poutres 6a à réaliser dans la suite du procédé et à fixer en outre les entrefers 40a entre les électrodes mobiles 12a et les électrodes supérieures fixes 18a.

Après élimination du masque de résine 50, et comme représenté sur les figures 15A et 15B, on dépose sur l'ensemble de la structure une nouvelle couche d'isolant électrique 60 que l'on doit pouvoir graver sélectivement par rapport à la couche de protection 48 et la couche d'oxyde 28. Cette couche 60 peut être réalisée en nitrure de silicium ou oxynitrure de silicium et être déposée par dépôt chimique en phase vapeur à basse pression (LPCVD) sur une épaisseur de 0,5µm environ.

On effectue ensuite une gravure de cette couche 60 en utilisant un nouveau masque de résine 62 de forme appropriée. Ce masque 62 fixe les dimensions des isolants à réaliser dans la couche 60 pour isoler électriquement du substrat 8 et du film de silicium 32 conducteurs les électrodes 18a et le trou de contact 25. La gravure de la couche 60 est réalisée par une gravure ionique réactive avec un mélange de CHF₃+SF₆ jusqu'à mise à nu du silicium 32 de surface.

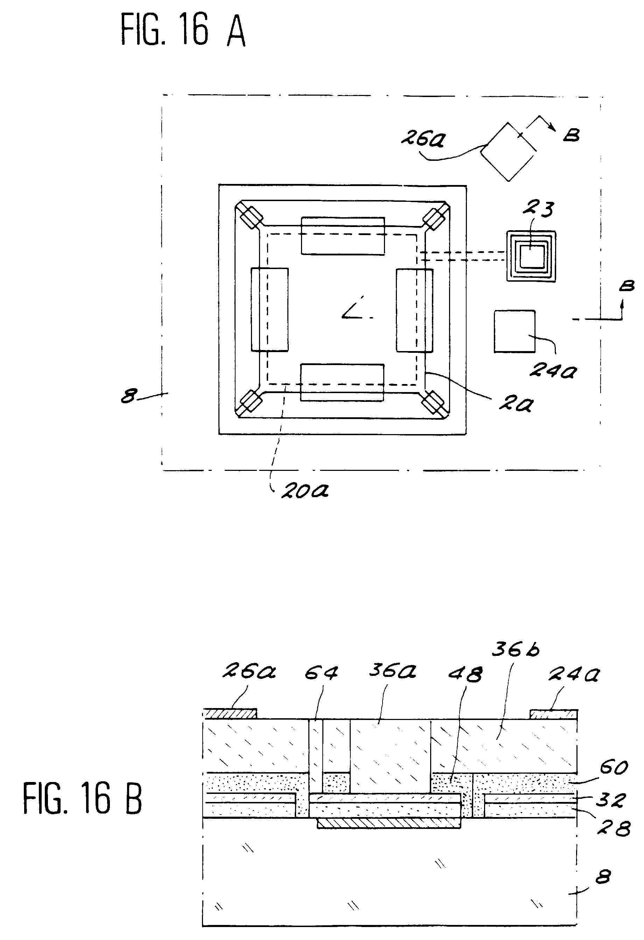

Après élimination du masque 62, on recouvre l'ensemble de la structure par du silicium conducteur, comme représenté sur les figures 16A et 16B afin d'épaissir la masse sismique 2a et réaliser les électrodes supérieures 18a.

Cette étape consiste à épitaxier une couche de silicium dopé P d'une épaisseur allant de 1 à 100µm sur toute la surface du substrat ou éventuellement à déposer une couche de silicium polycristallin dopé P sur l'ensemble de cette surface dont l'épaisseur est actuellement limitée à 2 ou 3µm du fait des techniques utilisées.

L'épitaxie de silicium (quelle que soit la technique utilisée) conduit à la réalisation d'un matériau monocristallin 36a sur toute les zones au contact de silicium monocristallin et d'un matériau polycristallin 36b dans les zones recouvrant la couche de nitrure de silicium 60 ou les plots isolants 48. Ainsi, toutes les parties critiques de la structure comme la masse sismique 2a et la zone 64 d'encastrement des poutres 6a sont réalisées en silicium monocristallin.

Sur la structure obtenue on dépose alors la couche métallique pour interconnexion et prise de contact que l'on grave suivant les motifs voulus pour réaliser les différents contacts métalliques 26a, 23 et 24a. Cette couche métallique peut être une couche d'or ou un multicouche de titane-nickel-or. La forme des contacts est alors réalisée par gravure chimique en utilisant un masque approprié de résine. La multicouche doit résister à la gravure de la silice gravée par une solution à base d'acide fluorhydrique.

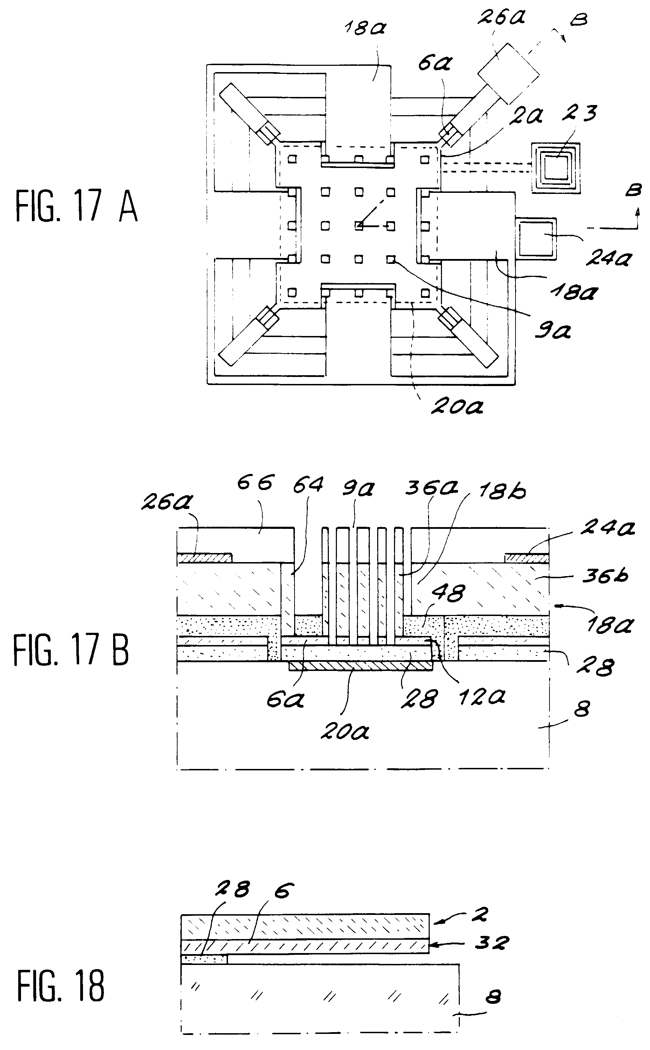

L'étape suivante du procédé est représentée sur les figures 17A et 17B. Cette étape consiste à graver le silicium 36a, 36b et 32 à l'aide d'un masque approprié 66 fixant les dimensions des poutres flexibles 6a, de l'encastrement 64 des poutres, des électrodes mobiles 12a et des électrodes 18a équipées de leur butée 18b. Cette gravure conduit en outre à la réalisation des trous 9a qui conféreront à la structure un amortissement mécanique optimum.

La densité des trous permet d'ajuster la fréquence de coupure de l'accéléromètre dans une large gamme d'accélérations sans modifier les dimensions de la structure de base.

Ces gravures sont effectuées jusqu'à l'oxyde 28 enterré sous la masse sismique 2a.

Le masque 66 utilisé pour la gravure peut être un masque de résine photosensible ou éventuellement un dépôt d'oxyde gravé selon la forme voulue.

La gravure est réalisée par voie sèche anisotrope en utilisant du SF₆ ou un mélange gazeux CCl₄+N₂.

On effectue alors l'élimination des plots isolants 48 ainsi que l'élimination partielle de la couche 28 enterrée de façon à dégager les éléments mobiles de l'accéléromètre et en particulier les poutres 6a, la masse mobile 2a et les électrodes 12a. L'élimination est effectuée dans une solution à base de HF à partir des bords de la structure et des orifices 9a. La structure est rincée puis séchée.

La technique SIMOX utilisée permet comme précédemment la réalisation d'un entrefer 40b (figure 10) bien maîtrisée permettant ainsi d'obtenir une capacité de valeur élevée.

De plus, les poutres flexibles 6a de sortie de la masse sensible étant réalisées dans la couche superficielle de silicium, de 0,2µm d'épaisseur environ, confère à l'accéléromètre une grande sensibilité.

Conformément à l'invention il est possible de réaliser sur le même substrat un accéléromètre sensible à l'axe Z tel que décrit en référence aux figures 9 à 17B et des accéléromètres à axe sensible parallèle au substrat comme décrits en référence aux figures 1 à 8.

La réalisation de ces différents accéléromètres peut être faite simultanément. Dans ce cas, il est nécessaire de prévoir un masquage des zones du substrat destinées à la réalisation des accéléromètres sensibles selon l'axe X ou Y pendant les étapes d'implantation de l'électrode enterrée (figures 11A et 11B).

Les autres étapes sont réalisées simultanément sur l'ensemble du substrat même en ce qui concerne les dépôts de plots isolants 48 et de nitrure de silicium 60 puisque la forme de ces isolants est fixée par gravure à travers de masques appropriés 50 et 62.

Le procédé de l'invention permet donc la fabrication en série, de façon simple et reproductible, de plusieurs accéléromètres diminuant ainsi leur coût de fabrication et permettant ainsi leur utilisation dans de nombreux domaines d'application.

Les modes de réalisation préférés des accéléromètres décrits n'ont été donnés qu'à titre illustratif, d'autres formes pouvant être envisagées.

De façon simplifiée, un accéléromètre réalisé selon le procédé de l'invention comporte, comme représenté sur la figure 18, une poutre flexible 6 de silicium monocristallin dopé, solidaire du substrat 8, à l'une de ses extrémités et via la couche d'isolant 28 gravée. Lorsque la poutre est suffisamment lourde (c'est-à-dire large et épaisse), elle peut jouer le rôle de masse sismique. Cependant, il est préférable d'équiper cette poutre 6 d'une masse supplémentaire 2 aussi en silicium monocristallin.

Des moyens de mesure des déformations de la poutre 6, intégrée ou non au substrat 8 sont en outre prévus.

Ainsi, le procédé de l'invention dans son principe général consiste à réaliser le film de silicium 32 sur le substrat 8 en les séparant par une couche d'isolant électrique 28 selon une technique silicium sur isolant ; à épitaxier éventuellement une couche de silicium monocristallin sur la poutre 6 pour l'épaissir ; à graver la structure jusqu'au substrat 8 pour former la poutre 6 mobile et la masse mobile et à éliminer partiellement la couche d'isolant 28 pour dégager la poutre et la masse mobile 2.

## Revendications

1. Procédé de fabrication d'un accéléromètre intégré comportant des éléments mobiles, caractérisé en ce qu'il comprend les étapes suivantes :
a) - réalisation d'un film de silicium monocristallin sur un substrat en silicium et séparé de ce dernier par une couche isolante ;
b) - gravure du film de silicium et de la couche isolante jusqu'au substrat pour fixer la forme des éléments mobiles ; et
c) - élimination partielle de la couche isolante pour dégager les éléments mobiles, le restant de la couche isolante rendant les éléments mobiles et le substrat solidaires,
et en ce qu'on épitaxie avant l'étape c) une couche de silicium monocristallin conducteur sur la structure obtenue en b), au moins à l'emplacement des éléments mobiles.

2. Procédé selon la revendication 1 de fabrication d'un accéléromètre comportant des moyens de mesure des déplacements de ces éléments mobiles, intégrés sur le substrat, caractérisé en ce que ces moyens sont définis en partie lors de l'étape b) dans le film de silicium et/ou de la couche épitaxiée qui sont alors conducteurs et en ce qu'on réalise des contacts électriques sur le silicium conducteur pour les moyens de mesure.

3. Procédé selon la revendication 1 ou 2, caractérisé en ce que le film de silicium est de type N.

4. Procédé selon l'une quelconque des revendications 1 à 3, caractérisé en ce que l'étape a) consiste à implanter des ions oxygène dans un substrat en silicium monocristallin conducteur et à recuire le substrat implanté.

5. Procédé selon l'une quelconque des revendications 1 à 4 de fabrication d'un accéléromètre comportant au moins une poutre flexible soutenant une masse sismique, caractérisé en ce qu'on effectue des ouvertures dans la masse sismique pour faciliter l'élimination de la couche isolante.

6. Procédé selon l'une quelconque des revendications 2 à 5 de fabrication d'un accéléromètre à éléments mobiles selon une direction parallèle au substrat, caractérisé en ce que la couche de silicium est épitaxiée sur l'ensemble de la structure et en ce qu'il comprend une étape de gravure de la couche de silicium épitaxiée pour former un écran électrostatique en forme de peigne faisant partie des moyens de mesure.

7. Procédé selon la revendication 1 de fabrication d'un accéléromètre comportant au moins une poutre supportant une masse sismique, la poutre et la masse étant mobiles selon une direction (Y) parallèle au substrat, caractérisé en ce qu'il comprend les étapes successives suivantes :
1) - implanter des ions oxygène dans un substrat en silicium monocristallin conducteur, puis recuire le substrat implanté, formant ainsi une couche d'oxyde enterrée séparant le film de silicium conducteur du substrat ;
2) - graver l'empilement film-couche d'oxyde jusqu'au substrat pour former la masse mobile, la poutre et une partie des moyens de mesure ;
3) - épitaxier une couche de silicium conducteur sur toute la structure obtenue en 2) pour épaissir la masse mobile et la poutre ;
4) - réaliser des contacts (métalliques sur les moyens de mesure ;
5) - graver la couche épitaxiée et le film de silicium jusqu'à la couche d'oxyde pour former des trous dans la masse mobile et un écran électrostatique (en forme de peigne constituant en partie les moyens de mesure ;
6) - éliminer partiellement la couche d'oxyde.

8. Procédé selon l'une quelconque des revendications 1 à 5 de fabrication d'un accéléromètre à éléments mobiles selon une direction (Z) perpendiculaire au substrat, caractérisé en ce qu'il comprend une étape de fabrication d'une électrode enterrée dans le substrat monocristallin et une étape de prise de contact sur cette électrode.

9. Procédé selon la revendication 8, caractérisé en ce qu'il comprend une étape de réalisation d'au moins une électrode de surface sur le film de silicium, le dépôt et la gravure d'une couche additionnelle d'isolant pour isoler électriquement le substrat de cette électrode de surface.

10. Procédé selon la revendication 9, caractérisé en ce que l'électrode de surface est réalisée en silicium polycristallin conducteur.

11. Procédé selon la revendication 9 ou 10, caractérisé en ce que l'on forme des plots sacrificiels sur le film de silicium avant de déposer par épitaxie une couche de silicium pour fixer l'entrefer de l'électrode de surface.

12. Procédé selon la revendication 1 de fabrication d'un accéléromètre comportant au moins une poutre (supportant une masse sismique, la poutre et la masse étant mobiles selon une direction perpendiculaire au substrat, et au moins une électrode de surface et au moins une électrode enterrée, caractérisé en ce qu'il comprend les étapes successives suivantes :
i) - implanter des ions oxygène dans un substrat en silicium monocristallin conducteur d'un premier type de conductivité, puis recuire le substrat implanté, formant ainsi une couche d'oxyde enterrée séparant le film de silicium conducteur du substrat ;
ii) - former une électrode enterrée dans le substrat ;
iii) - graver l'empilement film-couche d'oxyde jusqu'au substrat pour former la masse mobile, la poutre et une prise de contact sur l'électrode enterrée ;
iv) - former des plots sur la masse mobile et sur la poutre, éliminables sélectivement par rapport au silicium ;
v) - isoler électriquement la structure obtenue en iv) à l'emplacement prévu pour l'électrode de surface par un isolant électrique additionnel;
vi) - épitaxier une couche de silicium monocristallin conducteur sur la masse pour l'épaissir et déposer du silicium polycristallin à l'emplacement prévu pour l'électrode de surface ;
vii) - réaliser des contacts métalliques pour l'électrode de surface et l'électrode enterrée ;
viii) - graver l'empilement silicium épitaxié-film de silicium jusqu'à la couche d'oxyde pour former des ouvertures dans la masse mobile ;
ix) - éliminer les plots et partiellement la couche d'oxyde.

13. Procédé selon la revendication 12, caractérisé en ce que les plots sont en oxyde de silicium.

14. Procédé selon la revendication 8 ou 12, caractérisé en ce que l'électrode enterrée est formée par implantation locale d'ions dans le substrat d'un type de conductivité inverse de celle du substrat.

15. Procédé selon l'une quelconque des revendications 1 à 14, caractérisé en ce qu'il comprend une étape d'implantation d'ions de type P sur toute la surface du film de silicium, pour un film de silicium de type N.

16. Procédé selon l'une quelconque des revendications 1 à 15, caractérisé en ce que l'élimination de la couche d'isolant est effectuée par une gravure humide isotrope.

17. Procédé selon l'une quelconque des revendications précédentes, caractérisé en ce que l'on forme au moins un premier élément mobile à axe sensible perpendiculaire au substrat et au moins un second élément mobile à axe sensible parallèle au substrat.

18. Procédé selon l'une quelconque des revendication 8 à 16, caractérisé en ce qu'on forme au moins un élément mobile à axe sensible perpendiculaire au substrat.

## Patentansprüche

1. Verfahren zur Herstellung eines bewegliche Elemente umfassenden integrierten Beschleunigungsmessers,
**dadurch gekennzeichnet,** daß es die folgenden Schritte umfaßt:
a) - Herstellen eines monokristallinen Siliciumfilms auf einem Siliciumsubstrat, von diesem letzeren durch eine Isolierschicht getrennt;
b) - Ätzen des Siliciumfilms und der Isolierschicht bis zum Substrat, um die Form der beweglichen Elemente festzulegen; und
c) - partielles Entfernen der Isolierschicht, um die beweglichen Elemente freizumachen, wobei der verbleibende Rest der Isolierschicht die beweglichen Elemente und das Substrat verbindet,
**und dadurch,** daß man vor dem Schritt c) eine leitende monokristalline Siliciumschicht auf der in b) erhaltenen Struktur epitaktisch aufwachsen läßt, wenigstens an der Stelle bzw. dem Ort der beweglichen Elemente.

2. Verfahren nach Anspruch 1, auf dem Substrat integrierte Bewegungsmeßeinrichtungen dieser beweglichen Elemente umfassend, dadurch gekennzeichnet, daß diese Einrichtungen teilweise während des Schritts b) in dem Siliciumfilm und/oder der epitaksierten Schicht definiert werden, die dann leitend sind, und dadurch, daß man für die Meßeinrichtungen elektrische Kontakte auf dem leitenden Silicium herstellt.

3. Verfahren nach Anspruch 1 oder 2, dadurch gekennzeichnet, daß der Siliciumfilm vom Typ N ist.

4. Verfahren nach einem der Ansprüche 1 bis 3, dadurch gekennzeichnet, daß der Schritt a) darin besteht, Sauerstoff-Ionen in ein Substrat aus leitendem monokristallinem Silicium zu implantieren und das implantierte Substrat zu tempern.

5. Verfahren zur Herstellung eines wenigstens einen eine seismische Masse tragenden flexiblen Träger umfassenden Beschleunigungsmessers nach einem der Ansprüche 1 bis 4, dadurch gekennzeichnet, daß man in der seismischen Masse Öffnungen vorsieht, um die Entfernung der Isolierschicht zu erleichtern.

6. Verfahren zur Herstellung eines Beschleunigungsmessers nach ein 2 bis 5 mit in einer zum Substrat parallelen Richtung beweglichen Elementen, dadurch gekennzeichnet, daß man die - Siliciumschicht auf der gesamten Struktur epitaktisch aufwachsen läßt, und dadurch, daß sie einen Ätzschritt der epitaxierten Siliciumschicht umfaßt, um eine kammförmige elektrostatische Abschirmung zu bilden, die zu den Meßeinrichtungen gehört.

7. Verfahren zur Herstellung eines Beschleunigungsmessers nach Anspruch 1, der wenigstens einen eine seismische Masse tragenden Träger umfaßt, wobei der Träger und die Masse in einer zum Substrat parallelen Richtung (Y) beweglich sind, dadurch gekennzeichnet, daß es die folgenden sukzessiven Schritte umfaßt:
1) - Implantieren von Sauerstoff-Ionen in ein Substrat aus leitendem monokristallinem Silicium, dann Tempern des implantierten Substrats, wobei sich eine vergrabene Oxidschicht bildet, die den leitenden Siliciumfilm vom Substrat trennt;
2) - Ätzen des Stapels aus Film und Oxidschicht bis zum Substrat, um die bewegliche Masse, den Träger und einen Teil der Meßeinrichtungen zu bilden;
3) - Epitaktisches Aufwachsen einer leitenden Siliciumschicht auf der gesamten in 2) erhaltenen Struktur, um die bewegliche Masse des Trägers zu verdicken;
4) - Herstellen metallischer Kontakte auf den Meßeinrichtungen;
5) - Ätzen der epitaxierten Schicht und des Siliciumfilms bis zur Oxidschicht, um in der beweglichen Masse Löcher und eine kammförmige elektrostatische Abschirmung zu bilden, die teilweise die Meßeinrichtungen bilden;
6) - partielles Entfernen der Oxidschicht.

8. Verfahren zur Herstellung eines Beschleunigungsmessers nach einem der Ansprüche 1 bis 5 mit in einer zum Substrat senkrechten Richtung (Y) beweglichen Elementen, dadurch gekennzeichnet, daß es einen Schritt zur Herstellung einer in dem monokristallinen Substrat vergrabenen Elektrode und einen Schritt zur Kontaktherstellung auf dieser Elektrode umfaßt.

9. Verfahren nach Anspruch 8, dadurch gekennzeichnet, daß es einen Schritt zur Herstellung von wenigstens einer Oberflächenelektrode auf dem Siliciumfilm und die Abscheidung und Ätzung einer zusätzlichen Isolierschicht zum elektrischen Isolieren des Substrats von dieser Oberflächenelektrode umfaßt.

10. Verfahren nach Anspruch 9, dadurch gekennzeichnet, daß die Oberflächenelektrode aus leitenden polykristallinem Silicium hergestellt wird.

11. Verfahren nach Anspruch 9 oder 10, dadurch gekennzeichnet, daß man auf dem Siliciumfilm vor dem epitaktischen Aufwachsen einer Siliciumschicht Opfer-Abstandshalter bildet, um den Spalt der Oberflächenelektrode festzulegen.

12. Verfahren nach Anspruch 1, wenigstens einen eine seismische Masse tragenden Träger umfassend, wobei der Träger und die Masse in einer zum Substrat senkrechten Richtung beweglich sind, und wenigstens eine Oberflächenelektrode und wenigstens eine vergrabene Elektrode, dadurch gekennzeichnet, daß es die folgenden sukzessiven Schritte umfaßt:
i) - Implantieren der Sauerstoff-Ionen in ein Substrat aus leitendem monokristallinen Silicium eines ersten Konduktivitätstyps, dann Tempern des implantierten Substrats, wobei sich eine vergrabene Oxidschicht bildet, die den leitenden Siliciumfilm vom Substrat trennt;
ii) - Bilden einer in dem Substrat vergrabenen Elektrode;
iii) - Ätzen des Stapels aus Film und Oxidschicht zum Substrat, um die bewegliche Masse, den Träger und eine Kontaktstelle auf der vergrabenen Elektrode zu bilden;
iv) - Bilden von Abstandshaltern auf der beweglichen Masse und auf dem Träger, die in bezug auf das Silicium selektiv eliminiert werden können;
v) - elektrisches Isolieren der in iv) erhaltenen Struktur an der für die Oberflächenelektrode vorgesehenen Stelle durch ein zusätzliches elektrisches Isoliermaterial;
vi) - Epitaktisches Aufwachsen einer leitenden monokristallinen Siliciumschicht auf der Masse, um sie zu verdicken, und Abscheiden des polykristallinen Siliciums an der für die Oberflächenelektrode vorgesehenen Stelle;
vii) - Herstellen der metallischen Kontakte für die Oberflächenelektrode und die vergrabene Elektrode;
viii) - Ätzen des Stapels aus epitaktisch aufgewachsenem Silicium und Siliciumfilm bis zur Oxidschicht, um in der beweglichen Masse Öffnungen zu bilden;
ix) - Eliminieren der Abstandshalter und partiell der Oxidschicht.

13. Verfahren nach Anspruch 12, dadurch gekennzeichnet, daß die Abstandhalter aus Siliciumoxid sind.

14. Verfahren nach Anspruch 8 oder 12, dadurch gekennzeichnet, daß die vergrabene Elektrode durch lokales Implantieren von Ionen in das Substrat gebildet wird, deren Konduktivitätstyp zu dem des Substrats invers ist.

15. Verfahren nach einem der Ansprüche 1 bis 14, dadurch gekennzeichnet, daß es bei einem Siliciumfilm des Typs N einen Schritt der Implantation von Ionen des Typs P auf der gesamten Oberfläche des Siliciumfilms umfaßt.

16. Verfahren nach einem der Ansprüche 1 bis 15, dadurch gekennzeichnet, daß die Enfernung der Isolierschicht durch eine isotrope Trockenätzung erfolgt.

17. Verfahren nach einem der vorangehenden Ansprüche, dadurch gekennzeichnet, daß man wenigstens ein erstes bewegliches Element mit zum Substrat senkrechter empfindlicher Achse und wenigstens ein zweites bewegliches Element mit zum Substrat paralleler empfindlicher Achse bildet.

18. Verfahren nach einem der Ansprüche 8 bis 16, dadurch gekennzeichnet, daß man wenigstens ein bewegliches Element mit zum Substrat senkrechter empfindlicher Achse bildet.

## Claims

1. Process for the production of an integrated accelerometer having moving elements, characterized in that it comprises the following stages:
(a) producing a monocrystalline silicon film on a silicon substrate and separated from the latter by an insulating layer,
(b) etching the silicon film and insulating layer down to the substrate in order to fix the shape of the moving elements, and
(c) partial elimination of the insulating layer in order to free the moving elements, the remainder of the insulating layer rendering integral the moving elements and the substrate,
and in that a conductive monocrystalline silicon layer is epitaxied before stage (c) on the structure obtained in (b), at least at the location of the moving elements.

2. Process according to claim 1 for the production of an accelerometer having means for measuring the displacements of said moving elements and integrated onto the substrate, characterized in that these means are partly defined during stage (b) in the silicon film and/or the epitaxied layer, which are then conductive, and in that electric contacts are produced on the conductive silicon for the measuring means.

3. Process according to claim 1 or 2, characterized in that the silicon film is of the N type.

4. Process according to any one of the claims 1 to 3, characterized in that stage (a) consists of implanting oxygen ions in a conductive monocrystalline silicon substrate and annealing the implanted substrate.

5. Process according to any one of the claims 1 to 4 for producing an accelerometer having at least one flexible beam supporting a seismic mass, characterized in that openings are formed in the seismic mass to facilitate the elimination of the insulating layer.

6. Process according to any one of the claims 2 to 5 for the production of an accelerometer having moving elements in a direction parallel to the substrate, characterized in that the silicon layer is epitaxied on the complete structure and in that it comprises a stage of etching the epitaxied silicon layer to form a comb-shaped electrostatic screen forming part of the measuring means.

7. Process according to claim 1 for the production of an accelerometer having at least one beam supporting a seismic mass, the beam and the mass being mobile in a direction (Y) parallel to the substrate, characterized in that it comprises the following successive stages:
1) implanting oxygen ions in a conductive monocrystalline silicon substrate, followed by the annealing of the implanted substrate, thus forming a buried oxide layer separating the conductive silicon film from the substrate,
2) etching the film-oxide layer stack down to the substrate in order to form the moving mass, the beam and part of the measuring means,
3) epitaxying a conductive silicon layer over the entire structure obtained in 2) in order to thicken the moving mass and the beam,
4) producing metal contacts on the measuring means,
5) etching the epitaxied layer and the silicon film down to the oxide layer in order to form holes in the moving mass and a comb-shaped electrostatic screen in part constituting the measuring means,
6) partly eliminating the oxide layer.

8. Process according to any one of the claims 1 to 5 for the production of an accelerometer having moving elements in a direction (Z) perpendicular to the substrate, characterized in that it comprises a stage of producing a buried electrode in the monocrystalline substrate and a stage of contacting on said electrode.

9. Process according to claim 8, characterized in that it comprises a stage of producing at least one surface electrode on the silicon film, the deposition and etching of an additional insulator layer in order to electrically insulate the substrate from said surface electrode.

10. Process according to claim 9, characterized in that the surface electrode is made from conductive polycrystalline silicon.

11. Process according to claim 9 or 10, characterized in that sacrificial studs are formed on the silicon film before depositing by epitaxy a silicon layer in order to fix the air gap of the surface electrode.

12. Process according to claim 1 for the production of an accelerometer having at least one beam (supporting a seismic mass), the beam and the mass being mobile in a direction perpendicular to the substrate, and at least one surface electrode and at least one buried electrode, characterized in that it comprises the following successive stages:
i) implanting oxygen ions in a conductive monocrystalline silicon substrate having a first conductivity type and then annealing the implanted substrate, thus forming a buried oxide layer separating the conductive silicon film from the substrate,
ii) forming a buried electrode in the substrate,
iii) etching the film-oxide layer stack down to the substrate in order to form the moving mass, the beam and contacting the buried electrode, iv) forming studs on the moving mass and on the beam, which can be selectively eliminated with respect to the silicon,
v) electrically insulating the structure obtained in iv) at the location provided for the surface electrode by an additional electrical insulator, vi) epitaxying a conductive monocrystalline silicon layer on the mass in order to thicken and deposit polycrystalline silicon at the location provided for the surface electrode,
vii) producing metal contacts for the surface electrode and the buried electrode,
viii) etching the epitaxied silicon-silicon film stack down to the oxide in order to form openings in the moving mass,
ix) eliminating the studs and in part the oxide layer.

13. Process according to claim 12, characterized in that the studs are made from silicon dioxide.

14. Process according to claim 8 or 12, characterized in that the buried electrode is formed by the local implantation of ions in the substrate having a conductivity type which is the reverse of that of the substrate.

15. Process according to any one of the claims 1 to 14, characterized in that it comprises a stage of implanting P type ions over the entire surface of the silicon film in the case of a N type silicon film.

16. Process according to any one of the claims 1 to 15, characterized in that the insulating layer is eliminated by wet isotropic etching.

17. Process according to any one of the preceding claims, characterized in that formation takes place of at least one first moving element having a sensitive axis perpendicular to the substrate and at least one second moving element having a sensitive axis parallel to the substrate.

18. Process according to any one of the claims 8 to 16, characterized in that formation takes place of at least one moving element with a sensitive axis perpendicular to the substrate.
